(19) Europäisches Patentamt

European Patent Office

Office européen des brevets

(11) Veröffentlichungsnummer: **0 299 530 B1**

(12) **EUROPÄISCHE PATENTSCHRIFT**

(45) Veröffentlichungstag der Patentschrift: **18.03.92**

(51) Int. Cl.⁵: **G06K 19/06**

(21) Anmeldenummer: **88111437.5**

(22) Anmeldetag: **15.07.88**

(54) **Trägerelement zum Einbau in Ausweiskarten.**

(30) Priorität: **16.07.87 DE 3723547**

(43) Veröffentlichungstag der Anmeldung:
**18.01.89 Patentblatt 89/03**

(45) Bekanntmachung des Hinweises auf die
Patenterteilung:
**18.03.92 Patentblatt 92/12**

(84) Benannte Vertragsstaaten:
**AT BE CH DE ES FR GB IT LI LU NL SE**

(56) Entgegenhaltungen:
**EP-A- 0 107 061**
**EP-A- 0 201 952**
**FR-A- 2 337 381**
**FR-A- 2 520 541**
**FR-A- 2 548 857**

(73) Patentinhaber: **GAO Gesellschaft für Automation und Organisation mbH
Euckenstrasse 12
W-8000 München 70(DE)**

(72) Erfinder: **Haghiri-Tehrani, Yahya, Dipl.-Ing.
Winzererstrasse 98
W-8000 München 40(DE)**
Erfinder: **Barak, Renée-Lucia, Dipl.-Ing.
Säulenstrasse 2
W-8025 Unterhaching(DE)**

(74) Vertreter: **Klunker . Schmitt-Nilson . Hirsch
Winzererstrasse 106
W-8000 München 40(DE)**

## Beschreibung

Die Erfindung betrifft ein Trägerelement mit einem oder mehreren integrierten Schaltkreisen zum Einbau einer Ausweiskarte, bestehend aus einem Substrat, auf dessen Oberflächen mehrere Kontaktflächen vorgesehen sind, die über Leiterbahnen mit den entsprechenden Anschlußpunkten eines in einer Aussparung des Substrats oder auf dem Substrat angeordnet integrierten Schaltkreises verbunden sind, mit einer Gußmasse, die zumindest den integrierten Schaltkreis umgibt und vor mechanischen Belastungen schützt und mit einem die Gußmasse begrenzenden Rahmen.

Derartige Trägerelemente werden beispielsweise in Identifikations-, Kredit- oder Buchungskarten und dergleichen eingebaut.

Zur rationellen und damit kostengünstigen Herstellung dieser Karten wird vorzugsweise ein Halbfabrikat verwendet, bei dem auf einem mit Leiterbahnen versehenen Träger ein oder mehrere integrierte Bausteine montiert sind. Bei der Kartenherstellung wird dieses sogenannte Trägerelement in eine passend geformte Aussparung einer Karte eingesetzt. Um beim Einbau des Trägerelements in eine Karte einen ausreichend festen Sitz in der vorgesehenen Kartenöffnung zu erreichen, wird das Trägerelement mit einem Kleber in der Öffnung fixiert.

Es ist in diesem Zusammenhang bereits bekannt (EP-A1 201 952), Trägerelemente zur Befestigung in einer Ausweiskarte mit einer Haftkleberschicht zu versehen. Jedes Trägerelement besteht aus einem mit der Haftkleberschicht versehenen Substrat, auf dem ein IC-Baustein über Leiterbahnen (Golddrähte) mit Kontaktflächen verbunden ist. Die einzelnen Schichten des Trägerelements werden aus Endlosfilmen hergestellt. Die Haftkleberschicht ist, wie üblich, mit einer Schutzschicht versehen. Haftkleberschicht und Schutzschicht überdecken das Trägerelement mit Ausnahme des Bereichs, in dem sich IC-Baustein und Leiterbahnen befinden. Vor dem Einbau des Trägerelements in eine Karte wird die Schutzschicht von der Haftkleberschicht entfernt.

Um Schaltkreis und Leiterbahnen gegen chemische Einflüsse zu schützen, werden die Trägerelemente, solange sie noch im Endlosformat vorliegen, großflächig mit einer 10 bis 50 $\mu$m dünnen Lackschicht besprüht, die den IC-Baustein, die Leiterbahnen und die Schutzschicht gleichmäßig überzieht.

Bei dem vorgeschlagenen Verfahren können die Trägerelemente prinzipiell nur mit einer sehr dünnen Lackschicht besprüht werden, da auch die wieder zu entfernende Schutzschicht verfahrensbedingt von der Lackschicht überzogen ist. Bei dickeren Lackschichten ist durch das Abziehen der Schutzschicht eine Beschädigung der Lackschicht im Bereich der Leiterbahnen und damit eine Beschädigung der Leiterbahnen selbst nicht zu vermeiden.

Mit dem bekannten Vorschlag mag daher ein ausreichender Schutz gegen chemische Einflüsse erzielbar sein. Auf keinen Fall sind IC-Baustein und Leiterbahnen, die sowohl während der Herstellung als auch im Gebrauch der Karte häufigen Biege- und Druckbelastungen ausgesetzt sind, mit dem vorgeschlagenen Verfahren ausreichend gegen mechanische Belastungen geschützt. Um diesbezüglich einen wirkungsvollen mechanischen Schutz zu erreichen, müssen daher andere Maßnahmen ergriffen werden.

Die EP-OS 0 107 061 beschreibt beispielsweise ein Trägerelement, das aus einer mit Leiterbahnen versehenen Folie besteht. Um den IC-Baustein mit Hilfe üblicher Drahtverbindungen kontaktieren zu können und trotzdem die geforderte Kartendicke nicht zu überschreiten, wird der IC-Baustein in einem Stanzloch dieser Folie montiert. Zum Schutz der gegen mechanische Beanspruchungen empfindlichen Elemente wird hier auf der Oberseite der Folie zusätzlich ein ringförmiger Begrenzungskörper aufgebracht, der den IC-Baustein und die Drahtverbindungen einschließt und der mit einem Harz gefüllt wird. Nach dem Aushärten des Harzes wird die Oberseite des Begrenzungskörpers gemeinsam mit der Harzmasse abgeschliffen, damit die geforderte Dicke der herzustellenden Karte auch tatsächlich erreicht werden kann.

Bei diesem bekannten Vorschlag ist es vor allem im Hinblick auf eine kostengünstige Herstellung eines Trägerelements nachteilig, daß in einem separaten und zusätzlichen Arbeitsgang ein Rahmen aufgebracht werden muß, um ein Auslaufen einer zu Schutzzwecken auf den IC-Baustein aufzubringenden, aushärtenden Gußmasse zu verhindern. Andererseits ist ein begrenzendes Element notwendig, um die Gußmasse auf einen definierten Bereich zu begrenzen und mit vorbestimmter Dicke auf die zu schützenden Elemente aufbringen zu können. Ohne ein begrenzendes Element kann die Gußmasse, wenn überhaupt, nur mit Überdicke auf die zu schützenden Teile aufgebracht werden. Vor dem Einbau des Trägerelements in eine Ausweiskarte mit vorbestimmter Dicke muß dann aber das überschüssige Gußmaterial, beispielsweise durch Abschleifen, entfernt werden.

FR 2548 857 zeigt ein Trägerelement, bei dem die Gußmasse von einer Aussparung im Substrat begrenzt wird. Eine Kleberschicht ist nicht erwähnt.

Der Erfindung liegt nun die Aufgabe zugrunde, ein Trägerelement mit IC-Baustein zum Einbau in Ausweiskarten zu schaffen, bei dem trotz rationeller und kostengünstiger Herstellung die empfindlichen Bauteile sehr gut gegen mechanische Belastungen geschützt sind.

Gelöst wird diese Aufgabe gemäß dem kennzeichnenden Teil des Hauptanspruchs.

Ein bewährtes Verfahren zum Einbau von Trägerelementen in Ausweiskarten besteht darin, daß das Trägerelement mit Hilfe einer Klebeschicht mit dem Kartenkörper verbunden wird.

Die Erfindung zeichnet sich nun gegenüber dem genannten Stand der Technik vor allem dadurch aus, daß eine Aussparung in einer zum Einbau eines Trägerelements in eine Ausweiskarte ohnehin notwendigen Klebeschicht als Rahmen für die schützende Gußmasse dient. Dabei hat sich überraschend gezeigt, daß selbst bei einer sehr dünnen Klebeschicht die Funktion eines Begrenzungsrahmens gewährleistet ist. Diese Doppelfunktion der Klebeschicht erspart also das zusätzliche Aufbringen eines Rahmens, ohne auf die Vorteile der bekannten Begrenzungsrahmen verzichten zu müssen. Durch die Gußabdeckung kann der IC-Baustein allein oder zusammen mit den Verbindungsdrähten wirkungsvoll gegen mechanische und auch chemische Einflüsse geschützt werden, obwohl auf die zusätzliche Aufbringung eines speziellen Begrenzungsrahmens verzichtet werden kann. Zur Herstellung des Trägerelements sind also weniger Herstellungsschritte nötig. Die genaue Dosierung der Gußmasse bei gleichbleibender Größe der Aussparung (Stanzloch im Klebefilm) erlaubt zum einen den sparsamen Einsatz von Gußmasse und zum anderen die Herstellung eines Trägerelements mit einer gut einstellbaren und gleichbleibenden Dicke.

Die Trägerelemente werden im allgemeinen aus Endlosfilmen hergestellt. Hierbei werden die einzelnen Schichten des späteren Trägerelements als Endlosfilme von je einer Filmrolle abgespult und passergenau zusammengebracht. Die so produzierten Tägerelemente müssen dann zum Einbau in eine Ausweiskarte lediglich aus dem Filmlaminat ausgestanzt und in die Karte eingesetzt werden. Ein nach diesem Prinzip arbeitendes Herstellungsverfahren ist beispielsweise in der DE-OS 36 39 630 beschrieben.

Um die schützende Gußmasse auf das Trägerelement dosiert aufbringen zu können, ist es bei Anwendung des bekannten Verfahrens demnach lediglich erforderlich, den auf einer der Filmrollen befindlichen Klebeschicht-Film in regelmäßigen Abständen mit einer geeigneten Aussparung zu versehen. Dies kann auf einfache Weise entweder vorab oder auch in dem oben geschilderten Verfahrensablauf geschehen.

In einer bevorzugten Ausführungsform der Erfindung besteht das den IC-Baustein tragende Substrat aus einem Kunststoffilm aus Polyester, Polyimid oder einem ähnlichen Material. Der Film ist ganzflächig mit einer leitenden Schicht überzogen, aus der das gewünschte Konkaktdesign ausgeätzt ist. Für den IC-Baustein und die Zuführungen der Leiterbahnen zu den Kontaktflächen sind im Film mehrere Aussparungen vorgesehen. Auf der den Kontaktflächen gegenüberliegenden Seite des Films ist eine Heißkleberschicht aufgebracht, die eine Aussparung solcher Größe aufweist, daß der IC-Baustein und die den Kontaktflächen zugeordneten Aussparungen frei zugängig sind. Dieser frei zugängige Bereich ist mit einem geeigneten Gußharz gefüllt, wobei der Rand der Aussparung in der Heißkleberschicht die Harzmasse während des Auftragens in der flüssigen Phase begrenzt. Art des Harzmaterials, Mengendosierung und weitere in diesem Zusammenhang dem Fachmann bekannte Parameter sind so gewählt, daß einerseits IC-Baustein und Leiterbahnen sicher eingeschlossen sind und andererseits die Gesamtanordnung eine vorbestimmte Dicke nicht übersteigt.

Weitere Vorteile und Weiterbildungen der Erfindung ergeben sich aus den Unteransprüchen sowie den Ausführungsbeispielen, die nachfolgend anhand der Fig. beschrieben werden.

Darin zeigen:

Fig. 1 eine Ausweiskarte mit eingelagertem IC-Baustein in der Aufsicht,

Fig. 2 die Ausweiskarte nach Fig. 1 im Schnitt,

Fig. 3 ein Trägerelement im Schnitt,

Fig. 4 das Trägerelement aus Fig. 3 in der Aufsicht.

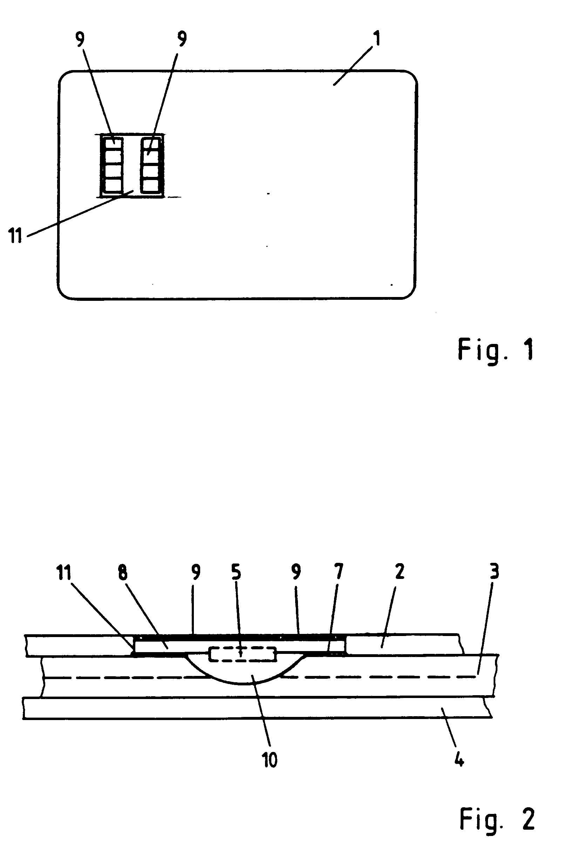

Die Fig. 1 und 2 zeigen eine aus mehreren Schichten bestehende Ausweiskarte, bei der in einer geeigneten Aussparung ein Trägerelement 11 implantiert ist. Die an der Kartenoberfläche liegenden Kontaktflächen 9 sind elektrisch mit einem Schaltkreis 5 verbunden.

In der gezeigten beispielhaften Ausführungsform besteht die Karte aus einer Kernschicht 3 sowie zwei Deckschichten 2 und 4. Das Trägerelement 11 besteht aus einem Substrat 8, auf dessen einer Seite die Kontaktflächen 9 liegen, die über Leiterbahnen mit einem auf der den Kontaktflächen gegenüberliegenden Seite des Substrats angeordneten IC-Baustein 5 verbunden sind. Zumindest der IC-Baustein 5 ist von einem Harztropfen 10 umgeben. Um das Trägerelement in eine Ausweiskarte einbetten zu können, sind Deck- und Kernschicht mit entsprechenden Aussparungen versehen. Die Aussparung der Deckschicht 2 ist in ihrem Umriß der Größe des Substrats 8, die der Kernschicht 3 in ihrem Umriß der Größe des Harztropfens 10 angepaßt.

Die in den Fig. gezeigte Karte wurde unter Anwendung von Wärme und Druck laminiert. Während des Laminiervorgangs wird dabei das Substrat mit Hilfe einer Heißkleberschicht 7 mit der Kernschicht 3 verbunden. Die Kernschicht 3 kann bei Anwendung eines Heißlaminierverfahrens mehrschichtig sein, wie durch eine strichlierte Linie in der Fig. 2 angedeutet, wobei die Schichten unterschiedlich große, der Form des Harztropfens 10 angepaßte, Aussparungen aufweisen. Bei der fertiggestellten Karte werden die Kernschichten aufgrund der Erweichung während des Laminierens lückenlos an den Harztropfen anschließen. Bei anderen Herstellungstechniken (z. B. Einbau des Trägerelements in eine bereits laminierte Karte) kann im Bereich des Harztropfens ein Hohlraum entstehen, der frei bleibt oder auch mit einem geeigneten Material ausgefüllt werden kann.

Bei der letztgenannten Herstellungsmethode kann ein Heiß-, aber auch ein Haftkleber verwendet werden. Der im Harztropfen 10 angedeutete IC-Baustein 5 kann auf verschiedene Arten mit den Kontaktflächen des Trägerelements verbunden sein.

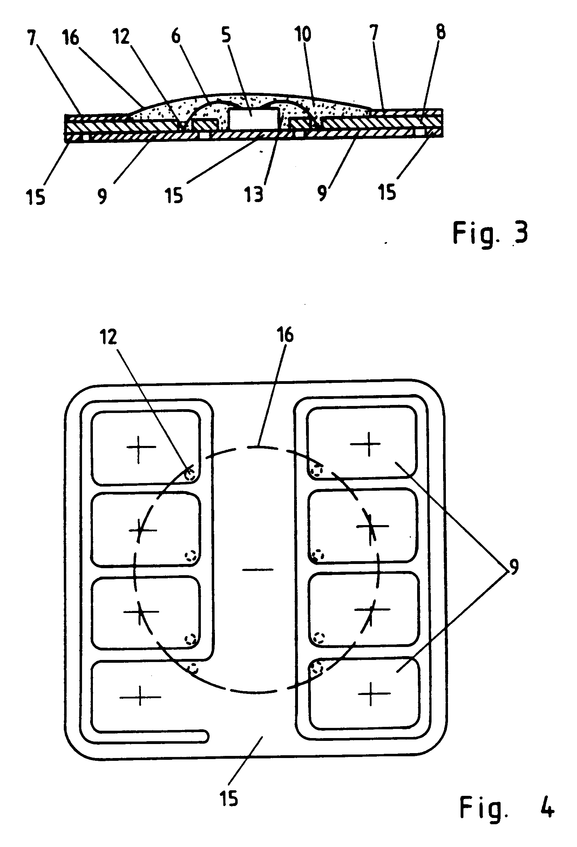

Fig. 3 und 4 zeigen eine beispielhafte Ausführungsform des in Fig. 2 grob skizzierten Trägerelements 11. Es besteht aus drei Schichten; einer leitenden Schicht 15, aus der das Kontaktdesign mit den Kontaktflächen 9 ausgeätzt ist, einem Substrat 8, beispielsweise aus Polyimid und einer Heißkleberschicht 7. Die im allgemeinen aus Kupfer hergestellten, vorzugsweise mit einer Nickel- und Goldauflage überzogenen Kontaktflächen 9 berühren sich nicht.

In dem gezeigten Ausführungsbeispiel ist der IC-Baustein 5 in einer Aussparung 13 des Substrats 8 direkt mit der leitenden Schicht, beispielsweise mit Hilfe eines Klebstoffs, verbunden.

Weitere Aussparungen 12 im Substrat sind derart plaziert, daß sie - gesehen von der Seite des Trägerelements, auf der der IC-Baustein angeordnet ist - den Zugang zu den Kontaktflächen 9 ermöglichen. So kann auf einfache Weise eine elektrische Verbindung hergestellt werden zwischen den Anschlußpunkten des IC-Bausteins 5 und den entsprechenden Kontaktflächen 9. In dem gezeigten Ausführungsbeispiel wurde die sogenannte Drahtbondtechnik eingesetzt, bei der feine Golddrähte 6 die elektrische Verbindung herstellen.

Die die Gußmasse 10 begrenzende Aussparung 16 in der Heißkleberschicht 7 hat eine solche Größe, daß der IC-Baustein 5, die Leiterbahnen 6 und die in den Aussparungen 12 liegenden Verbindungspunkte zwischen den Leiterbahnen 6 und den Kontaktflächen 9 in der Gußmasse 10 eingeschlossen sind. Die die Gußmasse begrenzende Aussparung 16 der Klebeschicht 7, die das Abfließen der Gußmasse in der flüssigen Phase verhindert, kann in der Dicke deutlich geringer sein, als die Dicke der Gußabdeckung im Bereich des IC-Bausteins oder der Verbindungsdrähte. Als Gußmasse wird vorzugsweise ein aushärtendes Harz verwendet. Viskosität und Menge der Gußmasse sind so eingestellt, daß die gewünschte Gesamtdicke des Trägerelements nicht überschritten wird, aber andererseits alle empfindlichen Elemente und Verbindungsstellen geschützt in der Gußmasse liegen. Die flächenmäßige Ausdehnung der Gußabdeckung ist abhängig von der Lage der Aussparungen 12 und der damit verbundenen Leiterbahnführung zu den Kontaktflächen. Man wird daher die Aussparungen 12 möglichst nahe in der Umgebung des IC-Bausteins 5 anordnen, damit die Aussparung 16 in der Klebeschicht 7 entsprechend klein und die verbleibende Klebefläche möglichst groß ist.

Die in der beschriebenen Ausführungsform verwendete Heißkleberschicht kann auch zusammen mit einer Schutzschicht aufgebracht werden, die vor oder auch nach dem Aufbringen der Gußmasse abgezogen wird. So wird bei der Herstellung der Trägerelemente auf einfache Art und Weise eine saubere Klebeoberfläche garantiert.

**Patentansprüche**

1. Trägerelement mit einem oder mit mehreren integrierten Schaltkreisen zum Einbau einer Ausweiskarte, bestehend aus einem Substrat, auf dessen Oberflächen mehrere Kontaktflächen vorgesehen sind, die über Leiterbahnen mit den entsprechenden Anschlußpunkten eines in einer Aussparung des Substrats oder auf dem Substrat angeordnet integrierten Schaltkreises verbunden sind, mit einer Gußmasse, die zumindest den integrierten Schaltkreis umgibt und vor mechanischen Belastungen schützt und mit einem die Gußmasse begrenzenden Begrenzungsrahmen, dadurch **gekennzeichnet**, daß das Substrat (8) auf der den Kontaktflächen (9) gegenüberliegenden Seite eine zur Verbindung des Substrats (8) mit einem Kartenkörper dienende Klebeschicht (7) aufweist und diese Klebeschicht (7) zumindest im Bereich des integrierten Schaltkreises (5) eine Aussparung (16) aufweist, die den Begrenzungsrahmen für die Gußmasse bildet.

2. Trägerelement nach Anspruch 1, dadurch **gekennzeichnet**, daß das Material der Gußmasse (10) in der Menge derart dosiert ist, daß sie im Bereich des IC-Bausteins (5) unter Tropfenbildung die Dicke der Klebeschicht (7) um ein Vielfaches übersteigt.

3. Trägerelement nach Anspruch 1, dadurch **gekennzeichnet**, daß die Klebeschicht eine Heißkleberschicht (7) ist.

4. Verfahren zur Herstellung eines Trägerelements nach Anspruch 1,

dadurch **gekennzeichnet**, daß auf einem mit IC-Baustein (5), Leiterbahnen (6) und Kontaktflächen (9) vorbereiteten Substrat (8) eine Klebeschicht (7) aufgebracht wird, die im Bereich des IC-Bausteins (5) eine Aussparung (16) aufweist und daß anschließend der durch die Aussparung gebildete Bereich mit einer Gußmasse (10) gefüllt wird, wobei die Dosierung der Gußmasse (10) derart eingestellt ist, daß einerseits der IC-Baustein (5) vollständig eingeschlossen ist und andererseits die Klebeschicht (7) vollständig frei bleibt.

## Claims

1. A carrier element having one or more integrated circuits to be incorporated into an identity card, comprising a substrate having on its surfaces a plurality of contact areas which are connected via strip conductor to the corresponding terminals of an integrated circuit disposed in an opening in the substrate or on the substrate, a casting compound surrounding at least the integrated circuit and protecting it from mechanical stresses, and a frame limiting the casting compound, **characterized** in that the substrate (8) has on the side opposite the contact areas (9) an adhesive layer (7) for connecting the substrate (8) with a card body, and this adhesive layer (7) has, at least in the area of the integrated circuit (5), an opening (16) which forms the limiting frame for the casting compound.

2. A carrier element according to claim 1, **characterized** in that the material of the casting compound (10) is dosed in such a way that the compound exceeds many times the thickness of the adhesive layer (7) forming a drop in the area of the IC module (5).

3. A carrier element according to claim 1, **characterized** in that the adhesive layer is a heatset adhesive layer (7).

4. A method for producing a carrier element according to claim 1, **characterized** in that an adhesive layer (7) is applied to a substrate (8) prepared with an IC module (5), strip conductors (6) and contact areas (9), said adhesive layer (7) having an opening (16) in the area of the IC module (5), and the area formed by the opening is then filled with a casting compound (10), the dosage of the casting compound (10) being adjusted in such a way that the IC module (5) is completely enclosed, on the one hand, and the adhesive layer (7) remains completely free, on the other hand.

## Revendications

1. Elément de support avec un ou plusieurs circuits intégrés pour incorporation dans une carte d'identification consistant en un substrat sur la surface duquel sont prévues plusieurs surfaces de contact qui sont reliées par des pistes conductrices à des points de jonction correspondants d'un circuit intégré disposé dans un évidement du substrat ou sur ce substrat, avec un matériau de coulée qui entoure au moins le circuit intégré et le protège des contraintes mécaniques et avec un cadre de limitation limitant le matériau de coulée, caractérisé en ce que le substrat (8) sur la face faisant vis-à-vis aux surfaces de contact (9) comporte une couche adhésive (7) servant à la liaison du substrat (8) avec un corps de carte et en ce que cette couche adhésive (7) comporte au moins dans le voisinage du circuit intégré (5) un évidement (16) qui sert de cadre de limitation pour le matériau de coulée.

2. Support selon la revendication 1, caractérisé en ce que le matériau de la masse de coulée (10) est dosé en une quantité telle que dans le voisinage du circuit intégré (5) par formation d'une goutte, il dépasse un certain nombre de fois l'épaisseur de la couche adhésive (7).

3. Support selon la revendication 1, caractérisé en ce que la couche adhésive est une couche d'un adhésif à chaud (7).

4. Procédé pour la fabrication d'un support selon la revendication 1, caractérisé en ce que sur un substrat (8) préparé avec un composant de circuit intégré (5), des pistes conductrices (6) et des surfaces de contact (9) on dépose une couche d'adhésif (7) qui ménage dans le voisinage du circuit intégré un évidement (16) et en ce qu'ensuite on remplit la zone formée par cet évidement avec un matériau de coulée (10), le dosage du matériau de coulée (10) étant ajusté de manière telle que, d'une part le composant de circuit intégré (5) soit complètement enrobé et que, d'autre part, la couche d'adhésif (7) reste entièrement libre.

Fig. 1

Fig. 2

Fig. 3

Fig. 4